# FASCICULE DE BREVET EUROPEEN

(11) **EP 2 469 589 B1**
(45) Date de publication et mention de la délivrance du brevet: **08.07.2015**
(21) Numéro de dépôt: 11194547.3
(22) Date de dépôt: 20.12.2011
(51) Int. Cl.: H01L 21/768

(54) **Dispositif pour connecter des nano-objets à des systemes électriques externes, et procédé de fabrication du dispositif**
Vorrichtung zum Verbinden von Nano-Objekten mit externen elektrischen Systemen, und Herstellungsverfahren einer solchen Vorrichtung
Device for connecting nano-objects to external electrical systems, and method for manufacturing the device

(30) Priorité: 23.12.2010 FR 1061128
(43) Date de publication de la demande: 27.06.2012
(73) Titulaire: Commissariat à l'Énergie Atomique et aux Énergies Alternatives, 75015 Paris (FR)
(72) Inventeur: Thuaire, Aurélie, 36500 BUZANCAIS (FR); Baillin, Xavier, 38920 CROLLES (FR); Sillon, Nicolas, 38120 SAINT EGREVE (FR)
(74) Mandataire: Ilgart, Jean-Christophe

(56) Documents cités:
- WO-A1-2009/022982

## Description

### DOMAINE TECHNIQUE

La présente invention concerne un dispositif pour connecter des nano-objets à des systèmes électriques externes, et un procédé de fabrication de ce dispositif.

Par « nano-objets », on entend des objets dont au moins l'une des dimensions se situe dans l'intervalle allant de 1 nm à 100 nm. Et, dans cette catégorie des nano-objets, on inclut les nanoparticules (organiques ou inorganiques), les nanotubes, les nanofils, les molécules et les associations de molécules, en particulier les molécules biologiques telles que les virus et les bactéries « de petite taille » par exemple.

L'invention trouve des applications notamment en électronique, en optique, en chimie et en biologie. En particulier, elle permet de produire, d'une part, des boîtiers de caractérisation moléculaire et, d'autre part, des puces hybrides, par exemple des circuits hybrides MOS/molécules.

L'invention permet, entre autres, d'intégrer l'électronique moléculaire à la microélectronique, en particulier à la technologie CMOS. Elle se situe à l'interface entre l'approche descendante (en anglais, *top-down approach)* et l'approche ascendante (en anglais, *bottom-up approach).*

On rappelle que l'approche descendante est celle dans laquelle, à partir de matériaux macroscopiques, on cherche à fabriquer des composants électroniques, par exemple des transistors MOS ou des capteurs, et ce en donnant à ces composants des tailles de plus en plus petites et des fonctionnalités de plus en plus grandes. L'approche ascendante vise, quant à elle, à fabriquer des éléments fonctionnels du point de vue électronique, optique ou chimique, à partir de molécules.

L'invention propose, entre autres, un dispositif permettant de caractériser et d'exploiter les propriétés électriques, optiques, chimiques, voire biologiques, de molécules que l'on a synthétisées à dessein. Ce dispositif est obtenu à l'aide d'outils, de procédés et d'infrastructures qui ont été développés en microélectronique pour la fabrication de transistors MOS avancés (transistors à faible largeur de grille).

L'invention propose aussi une nouvelle architecture permettant d'intégrer à la fois des composants moléculaires et des composants microélectroniques sur le même substrat.

Il convient de noter qu'à l'heure actuelle les molécules doivent être manipulées sous vide, à l'aide de pointes de taille nanométrique, par l'intermédiaire d'équipements qui sont peu compatibles avec la fabrication de composants à l'échelle industrielle : ces équipements sont essentiellement les STM, c'est-à-dire les microscopes à effet tunnel (en anglais, *scanning tunneling microscopes),* et les AFM, c'est-à-dire les microscopes à force atomique (en anglais, *atomic force microscopes).*

### ÉTAT DE LA TECHNIQUE ANTÉRIEURE

En ce qui concerne l'approche ascendante, pour positionner et caractériser électriquement des molécules, on connaît essentiellement, d'une part, les STM et les AFM et, d'autre part, la technique des jonctions à cassure (en anglais, *break junction technique).*

Les STM et les AFM sont très performants mais nécessitent de travailler dans des enceintes sous vide et ne sont pas adaptés à la caractérisation d'une grande quantité de composants. La technique des jonctions à cassure conduit, quant à elle, à des systèmes dont la géométrie (notamment le lieu de la cassure et la taille de la jonction créée) est difficile à maîtriser. Au sujet de cette technique, on se reportera par exemple au document suivant :
[1] C. Kergueris et al., Phys. Rev. B ― Condensed Matter, 59, 12505, 1999.
   En ce qui concerne l'approche descendante, on connaît un dispositif permettant de connecter un nano-objet à un circuit électrique externe par le document suivant auquel on se reportera :
[2] WO 2009/022982, Nano-interconnects for atomic and molecular scale circuits.
   Cependant, des pointes (en anglais, probes) sont nécessaires pour connecter le nano-objet au circuit électrique externe par l'intermédiaire de ce dispositif. Ce dernier est ainsi inadapté à une connexion directe à un circuit électrique tel qu'un circuit intégré par exemple.

De plus, ce dispositif ne permet ni un reroutage intégré des nano-objets entre eux ni un reroutage vers des systèmes électriques externes.

### EXPOSÉ DE L'INVENTION

La présente invention a pour but de remédier aux inconvénients précédents.

De par sa conception, le dispositif, objet de l'invention, peut être directement connecté à un système électrique externe tel qu'un circuit intégré par exemple : il intègre un reroutage qui peut être plus ou moins complexe entre ses faces supérieure et inférieure.

En outre, le dispositif de l'invention peut connecter des nano-objets hybridés sur sa face supérieure à des circuits microélectroniques tels que des transistors ou des diodes, formés avantageusement dans le même niveau que les plots de connexion de ces nano-objets.

Le procédé, objet de l'invention, est par ailleurs compatible avec un chauffage à température élevée : comme on le verra mieux par la suite, un passage à haute température (de l'ordre de 1000°C) peut s'avérer nécessaire à la fois pour activer des dopants après implantation de la zone d'accueil des nano-objets et pour restaurer la structure cristallographique de cette dernière (étape préalable au report contrôlé de nano-objets).

De façon précise, la présente invention a pour objet un dispositif pour connecter au moins un nano-objet à au moins un système électrique externe, le dispositif comprenant :
- un premier niveau comprenant au moins deux premiers éléments de contact électrique, prévus pour être connectés au nano-objet;
- un deuxième niveau comprenant au moins deux deuxièmes éléments de contact électrique, prévus pour être connectés au système électrique externe, les deuxièmes éléments ayant des dimensions supérieures aux dimensions des premiers éléments ; et
- un niveau intermédiaire, compris entre les premier et deuxième niveaux et permettant de relier les premiers éléments aux deuxièmes éléments,
   caractérisé en ce que :
- le premier niveau comprend en outre une première couche, pourvue des premiers éléments, les premiers éléments étant isolés électriquement du reste de la première couche;
- le deuxième niveau comprend en outre une deuxième couche, pourvue des deuxièmes éléments, les deuxièmes éléments étant isolés électriquement du reste de la deuxième couche, et une couche de liaison, disposée entre la deuxième couche et le niveau intermédiaire et comprenant au moins deux vias électriques traversants, respectivement en contact avec les deuxièmes éléments de contact électrique; et
- le niveau intermédiaire est prévu pour relier les vias du deuxième niveau aux premiers éléments de contact électrique et comprend un empilement d'au moins deux couches intermédiaires, respectivement pourvues d'un ensemble de lignes électriquement conductrices qui sont électriquement isolées du reste de la couche correspondante et d'un ensemble de vias électriques traversants qui sont isolés électriquement du reste de la couche correspondante.

La face supérieure du dispositif peut ainsi constituer une plateforme d'accueil de nano-objets, tandis que la face arrière du dispositif peut être mise en contact avec un système électrique approprié, disposant par exemple de plots de contact électrique à connecter aux plots du dispositif. Le système électrique peut-être notamment un circuit intégré d'un système de caractérisation ou d'un système de commande ou encore d'un système de lecture.

Selon l'invention, les première et deuxième couches et les couches intermédiaires peuvent être indépendamment isolantes, semiconductrices ou conductrices; lorsque l'une des ces couches est conductrice ou semiconductrice, les éléments conducteurs disposés dans cette couche sont électriquement isolés du reste de ladite couche par un diélectrique (par exemple une couche d'oxyde).

Selon un mode de réalisation particulier du dispositif, objet de l'invention, le premier niveau comprend plus de deux premiers éléments de contact électrique. Le niveau intermédiaire est alors adapté pour connecter au moins l'un des deuxièmes éléments de contact électrique à au moins deux des premiers éléments de contact électrique. Ce mode de réalisation particulier permet notamment de connecter un nano-objet présentant plus de deux connecteurs ou encore de connecter ensemble plusieurs nano-objets.

Dans l'invention, le premier niveau peut comprendre plus de deux premiers éléments de contact électrique en vue de les connecter à au moins deux nano-objets (ou à un seul nano-objet présentant plus de deux connecteurs); le niveau intermédiaire est alors adapté pour connecter les nano-objets l'un à l'autre. Ce mode de réalisation particulier permet notamment, en connectant différents nano-objets entre eux, de former un circuit moléculaire.

Selon un mode de réalisation particulier de l'invention, le premier niveau comprend en outre au moins un circuit microélectronique présentant des connexions électriques et le niveau intermédiaire est alors adapté pour connecter le ou les nano-objets aux connexions électriques du circuit microélectronique. Ce circuit microélectronique comprend par exemple un ou plusieurs transistors ou une ou plusieurs diodes, tels que des CMOS.

Le dispositif, objet de l'invention, peut comprendre en outre au moins un capot définissant au moins une cavité qui est adaptée pour enfermer le ou les nano-objets.

Ce capot peut être adapté pour permettre au(x) nano-objet(s) qu'il contient d'interagir avec le milieu extérieur au capot.

Chacune des cavités définies par le capot peut être sous atmosphère contrôlée et par exemple contenir un gaz ou un liquide, ou être sous vide. Le capot peut ainsi isoler tout ou partie du circuit moléculaire. Il peut isoler les nano-objets de l'environnement ambiant de façon collective ou individuelle. Et il peut présenter une ou plusieurs cavités qui peuvent accueillir des fluides éventuellement distincts.

Ce capot peut présenter des fonctionnalités et des propriétés avantageuses pour les nano-objets qu'il enferme : transparence à certaines longueurs d'ondes pour des applications optiques, porosité ou herméticité du capot, fonctionnalisation du capot pour des applications chimiques ou biologiques, insertion d'un getter...

L'invention concerne aussi un procédé de fabrication d'un dispositif pour connecter au moins un nano-objet à au moins un système électrique externe, dans lequel :
- on forme un premier niveau comprenant une première couche, pourvue d'au moins deux premiers éléments de contact électrique qui sont isolés électriquement du reste de la première couche et sont prévus pour être connectés au nano-objet ;
- on forme un niveau intermédiaire comprenant un empilement d'au moins deux couches intermédiaires, respectivement pourvues d'un ensemble de lignes électriquement conductrices qui sont isolées électriquement du reste des couches intermédiaires et d'un ensemble de vias électriques traversants qui sont isolés électriquement du reste des couches intermédiaires et qui sont respectivement en contact, d'un côté, avec les premiers éléments et, de l'autre côté, avec les lignes électriquement conductrices; et
- on forme un deuxième niveau comprenant une deuxième couche, pourvue d'au moins deux deuxièmes éléments de contact électrique qui sont isolés électriquement du reste de la deuxième couche et sont prévus pour être connectés au système électrique externe, et une couche de liaison, disposée entre la deuxième couche et le niveau intermédiaire et comprenant au moins deux autres vias électriques traversants, respectivement en contact, d'un côté, avec les deuxièmes éléments de contact électrique et, de l'autre côté, avec les lignes électriquement conductrices du niveau intermédiaire.

Selon un mode de réalisation préféré du procédé, objet de l'invention, les lignes conductrices d'au moins un des niveaux, pris parmi le premier niveau, le deuxième niveau et le niveau intermédiaire, sont en silicium et les vias sont formés par siliciuration d'ouvertures préalablement formées sur lesdites lignes dans la ou les couches du niveau correspondant et par remplissage de tout ou partie desdites ouvertures par un matériau électriquement conducteur.

Selon un mode de réalisation préféré du procédé, objet de l'invention, pour former le deuxième niveau _{:}
- on utilise un substrat comprenant des vias électriques non traversants,
- on reporte ce substrat sur le niveau intermédiaire,
- on amincit ce substrat pour obtenir les autres vias électriques traversants, et
- on forme la couche de liaison et les deuxièmes éléments de contact électrique sur le substrat ainsi aminci.

En variante, pour former le deuxième niveau, on reporte, sur le niveau intermédiaire le substrat comprenant les vias électriques traversants, la couche de liaison, et les deuxièmes éléments de contact électrique.

De préférence, le substrat comprenant le deuxième niveau est reporté sur le niveau intermédiaire par collage direct, ou collage moléculaire. Ce collage peut être de type SDB (pour Silicon Direct Bonding). Néanmoins, d'autres types de collage peuvent également convenir.

De préférence, la première couche est semiconductrice et l'on forme les premiers éléments de contact électrique par implantation de dopants dans la première couche.

Selon un mode de réalisation préféré de l'invention, pour former le premier niveau, on utilise un substrat de type silicium sur isolant, comprenant un substrat de base, une couche d'oxyde sur le substrat de base et une couche de silicium sur la couche d'oxyde, la première couche est constituée par la couche de silicium et, après avoir reporté le deuxième niveau sur le niveau intermédiaire, lui-même étant formé sur le premier niveau, on élimine le substrat de base et la couche d'oxyde.

Dans un procédé avantageux pour l'invention, on recuit la structure ainsi obtenue pour activer les dopants et restaurer la structure cristalline (par exemple à une température de l'ordre de 1000°C). Ce recuit permet également, dans le cas de l'utilisation d'un report du deuxième niveau, de renforcer les forces de collage.

Selon un mode de réalisation avantageux pour l'invention, on peut reporter un capot, présentant au moins une cavité, sur le premier niveau du dispositif.

Ce capot peut d'ailleurs être fait de matériaux permettant de garantir une fonction particulière du capot pour une application donnée (transparence, porosité, etc...).

Selon un mode de réalisation préféré, le capot est reporté par collage direct sur le premier niveau du dispositif.

Selon un mode de réalisation avantageux pour l'invention, le capot est reporté de façon temporaire, faisant ainsi du dispositif une interface ou plateforme réutilisable), ou de façon permanente.

### BRÈVE DESCRIPTION DES DESSINS

La présente invention sera mieux comprise à la lecture de la description d'exemples de réalisation donnés ci-après, à titre purement indicatif et nullement limitatif, en faisant référence aux dessins annexés sur lesquels :
- les figures 1 à 5 sont des vues en coupe schématiques de modes de réalisation particuliers du dispositif, objet de l'invention, et
- les figures 6A à 6F illustrent schématiquement diverses étapes d'un procédé de fabrication d'un dispositif conforme à l'invention.

### EXPOSÉ DÉTAILLÉ DE MODES DE RÉALISATION PARTICULIERS

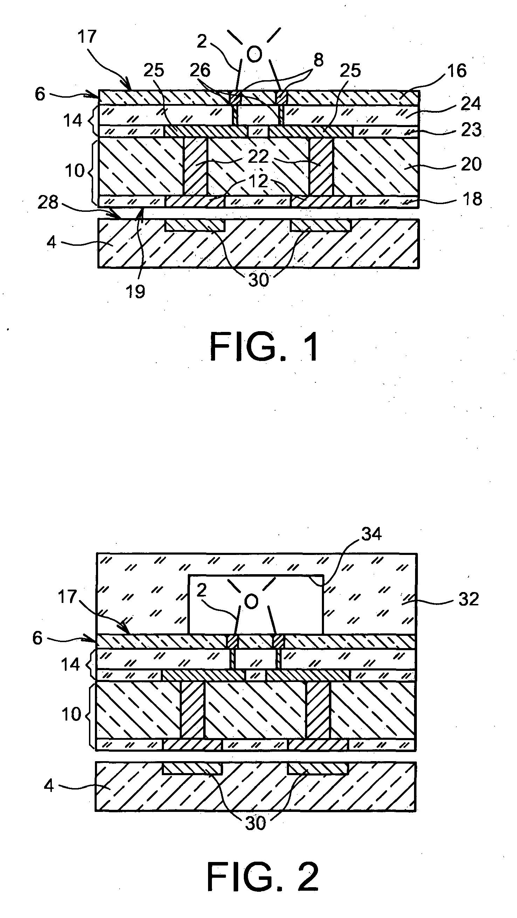

La figure 1 est une vue en coupe schématique d'un premier mode de réalisation particulier du dispositif, objet de l'invention.

Dans l'exemple de la figure 1, le dispositif est destiné à connecter un nano-objet 2, par exemple une molécule, à un système électrique externe 4, par exemple un circuit intégré tridimensionnel.

Le dispositif de la figure 1 comprend :
- un premier niveau 6, ou niveau supérieur, comprenant deux éléments de contact électrique 8, ou plots de contact supérieurs, prévus pour être connectés au nano-objet 2 (interconnexions nanométriques),
- un deuxième niveau 10, ou niveau inférieur, comprenant deux éléments de contact électrique 12, ou plots de contact inférieurs, prévus pour être connectés au circuit électrique externe 4 (interconnexions micrométriques), et
- un niveau intermédiaire 14, compris entre le niveau supérieur 6 et le niveau inférieur 10, et permettant d'établir une liaison électrique entre les plots supérieurs 8 et les plots inférieurs 12.

Conformément à l'invention, le niveau supérieur 6 comprend en outre une couche de préférence électriquement isolante ou semiconductrice 16 dont une face constitue la face avant 17 du dispositif et dans laquelle sont les plots 8. Comme on le voit, chacun de ceux-ci s'étend sur toute l'épaisseur de la couche 16 et affleure ainsi les deux faces de celle-ci.

Le niveau inférieur 10 comprend une couche 18 qui est de préférence électriquement isolante, dont une face constitue la face arrière 19 du dispositif et dans laquelle sont les plots 12. Chacun de ceux-ci s'étend aussi sur toute l'épaisseur de la couche 18 et affleure ainsi les deux faces de celle-ci.

De plus, le niveau inférieur 10 comprend une couche de liaison 20, disposée entre la couche 18 et le niveau intermédiaire 14. La couche 20 comprend deux vias électriques traversants 22, ou vias inférieurs.

Le niveau intermédiaire 14 est prévu pour relier respectivement les vias inférieurs 22 aux plots supérieurs 8 et comprend un empilement de deux couches intermédiaires 23 et 24.

La couche 23 est comprise entre la couche 20 et la couche 24 et pourvue de deux lignes électriquement conductrices 25 qui sont isolées électriquement du reste de la couche ; tandis que la couche 24 est pourvue de deux vias électriques 26, ou vias intermédiaires, qui sont isolés électriquement du reste de la couche. Dans cet exemple, chaque ligne conductrice 25 s'étend sur toute l'épaisseur de la couche 23 et affleure ainsi les deux faces de celle-ci.

Comme on le voit, chaque via 26 est relié, d'un côté, à un plot supérieur 8, et, de l'autre côté, à une ligne 25. Et chaque via 22 est relié, d'un côté, à un plot inférieur 12 et, de l'autre côté, à une ligne 25.

La face supérieure 17 du dispositif de la figure 1 peut ainsi constituer une plateforme d'accueil de nano-objets, tandis que la face arrière 19 du dispositif peut être mise en contact avec un système électrique approprié 4, disposant par exemple de plots de contact électrique 30 à connecter aux plots ou éléments 12 du dispositif.

Le système électrique peut-être notamment un circuit intégré d'un système de caractérisation ou d'un système de commande ou encore d'un système de lecture.

Selon l'invention, les première et deuxième couches et les couches intermédiaires peuvent être indépendamment isolantes, semiconductrices ou conductrices; lorsque l'une de ces couches est conductrice ou semiconductrice, les éléments conducteurs disposés dans cette couche sont électriquement isolés du reste de ladite couche par un diélectrique (par exemple une couche d'oxyde).

Ce dispositif permet, par exemple, de déterminer des propriétés électriques d'une molécule. Pour ce faire, on place le dispositif dans une enceinte de mesure appropriée (non représentée), on fait le vide dans cette enceinte, on connecte la molécule à caractériser entre les deux plots supérieurs 8, on applique une tension entre les deux plots inférieurs 12 (et donc entre les plots supérieurs 8) et l'on mesure le courant qui traverse la molécule.

Cela permet, par exemple, de tracer des caractéristiques courant-tension de la molécule.

L'application de la tension et la mesure du courant peuvent s'effectuer par l'intermédiaire d'un circuit intégré approprié 4. Une face 28 de ce dernier comporte des plots de contact électrique 30 que l'on peut connecter respectivement aux plots 12 après avoir mis la face 28 directement en contact avec la face arrière 19 du dispositif (face libre de la couche 18).

Au lieu d'un tel circuit intégré 4, on peut utiliser un appareil de mesure macroscopique approprié, pourvu de pointes (en anglais, probes), et appliquer celles-ci respectivement contre les plots inférieurs 12 du dispositif (qui constitue une sorte de connecteur du fait de ces plots).

Il convient de noter que les plots supérieurs 8 constituent, en quelque sorte, une prise de contact qui permet de s'affranchir des pointes de taille nanométrique que comportent les AFM et les STM.

La figure 2 est une vue en coupe schématique d'un autre mode de réalisation particulier du dispositif, objet de l'invention.

Le dispositif représenté sur la figure 2 résulte de l'adjonction d'un capot au dispositif que l'on a décrit en faisant référence à la figure 1. Plus précisément, on ajoute à ce dispositif un capot 32 adapté pour enfermer ou isoler le nano-objet 2. Le capot 32 est fixé de façon étanche à la face supérieure 17 du dispositif et définit donc une cavité étanche 34 dans laquelle est placé le nano-objet 2.

Il est ainsi possible d'analyser ce nano-objet dans un fluide, c'est-à-dire un gaz ou un liquide, ou sous vide. Et lorsque le fluide est un gaz, on peut choisir sa température, par exemple la température ambiante (environ 20°C), ainsi que sa pression, par exemple la pression ambiante (environ 10⁵ Pa) lorsqu'il s'agit d'un gaz.

Pour avoir le vide ou un liquide ou un gaz dans la cavité 34, il suffit de mettre le dispositif sous vide ou dans un liquide ou dans un gaz (à la pression choisie) et de fixer ensuite le capot 32 de façon étanche à la face 17 du dispositif.

Le fluide peut ensuite être laissé à la température ambiante ou porté à une température plus élevée en le chauffant par l'intermédiaire du capot (à condition que ce dernier soit thermiquement conducteur).

Contrairement au dispositif de la figure 1, le dispositif de la figure 2 permet de manipuler un nano-objet en dehors de toute enceinte spécifique. Cela permet, pour certaines applications, de passer le nano-objet encapsulé d'un outil de caractérisation à l'autre, voire d'un laboratoire à l'autre.

De plus, on donne au capot 32 des spécifications qui sont en accord avec les applications envisagées pour le dispositif dont il fait partie. Par exemple, dans le domaine de l'optique, on peut avoir besoin d'un capot transparent pour la caractérisation de certaines propriétés optiques ; et dans le domaine de la chimie ou de la biologie, on peut avoir besoin d'un capot poreux ou fonctionnalisé pour la caractérisation de certaines propriétés chimiques ou biologiques.

Par « capot fonctionnalisé », on entend un capot sur lequel on réalise un dépôt de surface qui lui confère des propriétés additionnelles (propriétés de surface). Il peut s'agir d'un capot hydrophobe, d'un capot antifongique...etc.

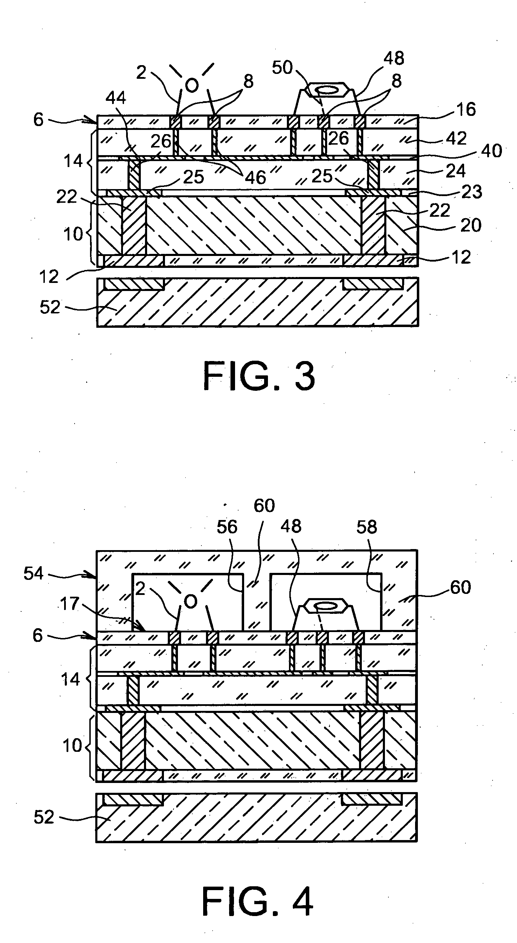

La figure 3 est une vue en coupe schématique d'un autre mode de réalisation particulier du dispositif, objet de l'invention.

Comme on le voit, le dispositif représenté sur cette figure comprend un système d'interconnexion qui est plus complexe que ceux des dispositifs des figures 1 et 2 et permet ainsi, par exemple, de former des circuits électriques entre plusieurs nano-objets; le niveau intermédiaire 14 est prévu à cet effet.

Dans l'exemple représenté sur la figure 3, le deuxième niveau 10 est identique à celui des figures 1 et 2.

Le premier niveau 6 comprend, quant à lui, plus de deux plots de contact électrique 8 : dans l'exemple, il y en a cinq ; dans le cas général, ce niveau comprend autant de plots qu'il y a de connexions à établir avec les nano-objets.

Et le niveau intermédiaire 14 est un empilement de plus de deux couches : il y en a quatre dans l'exemple.

En plus des couches intermédiaires 40 et 42, respectivement pourvues des lignes 44 et des vias 46, ce niveau 14 comprend deux autres couches intermédiaires 24 et 23, respectivement pourvues d'un ensemble de vias électriques 26 et d'un ensemble de lignes conductrices 25. La couche 24 est comprise entre la couche 40 et la couche 23 ; et cette dernière est au dessus de la couche 10 (deuxième niveau).

En plus du nano-objet 2, connecté entre deux des plots 8, un autre nano-objet 48, par exemple une molécule à trois connecteurs, est connecté entre trois autres de ces plots 8.

Le dispositif de la figure 3 peut encore être connecté directement, par l'intermédiaire des plots inférieurs 12, à un circuit intégré 52 permettant, par exemple, d'appliquer une tension entre ces plots et de mesurer le courant qui en résulte dans un circuit établi entre les nano-objets.

La figure 4 est une vue en coupe schématique d'un autre mode de réalisation particulier du dispositif, objet de l'invention.

Le dispositif représenté sur cette figure 4 résulte de l'adjonction d'un capot au dispositif que l'on a décrit en faisant référence à la figure 3. Plus précisément, on ajoute à ce dernier dispositif un capot 54 adapté pour enfermer ou isoler les nano-objets 2 et 48. Le capot 54 est fixé de façon étanche à la face supérieure 17 du dispositif et définit deux cavités 56 et 58 qui sont séparées par une paroi 60. Les nano-objets 2 et 48 sont respectivement placés dans les cavités 56 et 58.

L'utilisation de deux cavités permet d'étudier des nano-objets qui sont placés dans des fluides distincts. Toutefois, on peut prévoir une seule cavité pour y placer les deux nano-objets et les mettre sous vide ou les exposer au même fluide ; la paroi 60 est alors supprimée. Le capot peut en effet isoler les éléments de façon collective de l'environnement ambiant, ou les isoler de façon individuelle, par exemple dans le cas de molécules fonctionnant avec des stimuli différents.

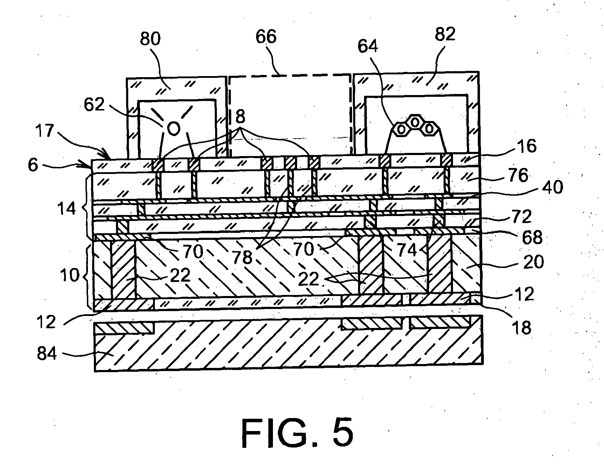

La figure 5 est une vue en coupe schématique d'un autre mode de réalisation particulier du dispositif, objet de l'invention.

Le dispositif représenté sur cette figure 5 permet l'hybridation de l'électronique moléculaire et de la microélectronique : à ce dispositif, on intègre à la fois un ou plusieurs nano-objets, par exemple des molécules formant un circuit électronique moléculaire, et un circuit microélectronique par exemple de type CMOS (approche descendante). Dans l'exemple représenté, deux molécules 62 et 64 et un ensemble 66 de transistors MOS sont intégrés au dispositif.

Le système d'interconnexion, que comporte ce dispositif, permet de former un circuit électrique non seulement entre les molécules 62 et 64 mais encore entre ces dernières et l'ensemble 66 des transistors MOS ou, plus généralement, entre les molécules et un circuit microélectronique. Le niveau intermédiaire 14 est prévu à cet effet.

Comme on le voit, le niveau supérieur 6 du dispositif de la figure 5 comprend plusieurs plots 8 (dans la couche 16) ; le niveau inférieur 10 comprend plusieurs plots 12 (dans la couche 18) et ces plots 12 sont associés à plusieurs vias électriques traversants 22 (dans la couche 20) ; et le niveau intermédiaire 14 est un empilement de plusieurs couches intermédiaires, pourvues chacune de vias électriques ou de lignes conductrices, qui sont isolés électriquement du reste de la couche.

Plus précisément, la couche intermédiaire la plus basse du niveau 14, couche qui a la référence 68, comporte des lignes conductrices 70 pour se connecter aux vias du niveau inférieur 10 ; au dessus de la couche 68 se trouve une autre couche intermédiaire 72 pourvue de vias électriques 74 connectés aux lignes 70, etc... ; et la couche intermédiaire la plus haute du niveau 14, couche qui a la référence 76, est pourvue de vias électriques 78 qui sont connectés aux plots 8 du niveau supérieur 6. On note aussi que, dans l'exemple représenté, certains des plots inférieurs 12 sont connectés à plus d'un plot supérieur 8.

Dans certaines applications du dispositif de la figure 5, on peut prévoir une interaction des molécules avec leur environnement pour constituer des capteurs optiques, chimiques ou biologiques.

Un ou plusieurs capots peuvent être prévus sur la face supérieure 17 du dispositif, pour enfermer le circuit électronique moléculaire ou des parties de celui-ci. Dans l'exemple représenté sur la figure 5, les molécules 62 et 64 sont respectivement enfermées de façon étanche dans des cavités délimitées par des capots 80 et 82.

Comme précédemment, un circuit électrique, tel qu'un circuit intégré 84, peut être directement connecté au dispositif de la figure 5 par l'intermédiaire des plots inférieurs 12.

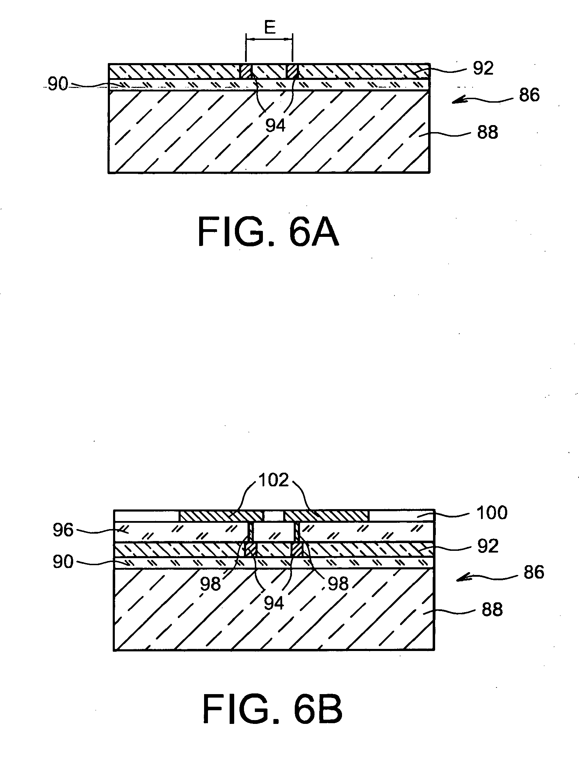

On va maintenant décrire des exemples du procédé de fabrication d'un dispositif conforme à l'invention, en faisant référence aux figures 6A à 6F.

Dans ces exemples, on utilise essentiellement des techniques qui ont été développées pour la microélectronique.

Pour fabriquer le dispositif, on utilise un substrat « silicium sur isolant » (en anglais, silicon *on insulator)* 86 (figure 6A), ou substrat SOI.

Il comprend un substrat de silicium massif (en anglais, *bulk silicon)* 88, une couche de silice 90, ou couche d'oxyde enterré (en anglais, *buried* oxide), sur le substrat 88, et une couche mince de silicium 92 sur la couche de silice 90.

On commence par former des éléments de contact 94 dans la couche de silicium 92. Ces éléments sont au nombre de deux dans l'exemple décrit (dans le cas général, il y en a au moins deux) et sont destinés à constituer les plots de contact supérieurs du dispositif. La couche 92 et les plots 94 constituent le niveau supérieur de ce dispositif.

Pour former les plots 94, on procède à une implantation de dopants, par exemple du bore, du phosphore ou de l'arsenic, dans toute l'épaisseur de la couche de silicium 92, à partir de la face avant du substrat 86 (face libre de la couche 92).

Cette implantation est effectuée à travers un masque (non représenté). Ce masque est défini par lithographie par faisceau d'électrons, de façon que l'espacement E, ou distance, entre deux zones dopées entre lesquelles on veut connecter un nano-objet, par exemple une molécule, soit égale à la taille du nano-objet ou, plus précisément, à la distance entre les deux points de connexion du nano-objet.

L'espacement E est de l'ordre de quelques nanomètres à quelques centaines de nanomètres.

Au lieu de former les plots supérieurs 94 par implantation, il est envisageable de les former par fonctionnalisation de la surface correspondant à l'accueil des nano-objets (dépôt de SAM (pour Self-Assembled Monolayer) par exemple).

On forme ensuite le niveau intermédiaire du dispositif (figure 6B). Ce niveau comporte un empilement de plusieurs couches, deux dans l'exemple décrit.

Pour ce faire, on forme une couche diélectrique 96 sur la couche 92. Dans cette couche 96, on forme des vias électriques 98, ou vias supérieurs, qui sont en contact avec les plots 94. Ensuite, on forme une autre couche diélectrique 100 sur la couche 96 ; et, dans cette couche 100, on forme des lignes conductrices 102 qui sont en contact avec les vias supérieurs 98.

A titre purement indicatif et nullement limitatif, pour former la couche 96, on dépose 0,25µm à 0,5µm de silice ; pour former les vias supérieurs 98, on effectue successivement une lithographie, une gravure, un décapage (en anglais, stripping), un dépôt de matériau conducteur présentant une bonne tenue en température, par exemple du tungstène, du polysilicium ou des nanotubes de carbone. Le procédé s'achève avec un CMP ou polissage mécano-chimique (en anglais, *chemical mechanical polishing) .*

En outre, une siliciuration peut être effectuée afin réduire les résistances de contact entre le plot et le via.

Cette siliciuration consiste à former un composé à base de silicium et du métal de remplissage du via afin que la résistivité du siliciure formé, intermédiaire entre celle du silicium et celle du matériau conducteur, facilite le passage du courant entre les deux matériaux.

Le siliciure est en général formé à haute température, supérieure à 500°C, mais plus fréquemment à une température de l'ordre de 700°C à 800°C.

Les mêmes techniques (lithographie, gravure, décapage, dépôt, CMP) peuvent être utilisées pour la formation de la couche 100 et des lignes 102.

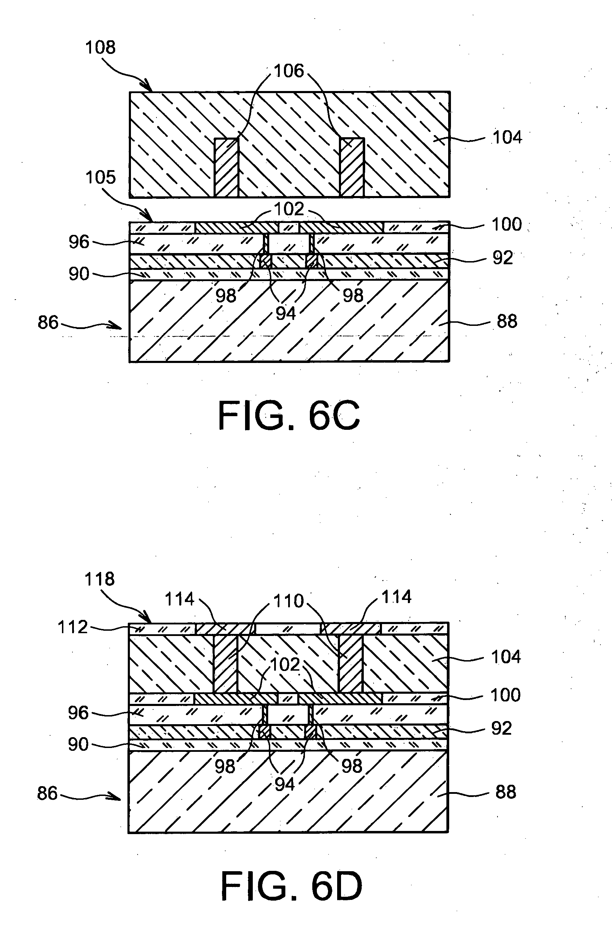

Ensuite (figure 6C), on reporte un substrat 104 sur la face libre 105 de la couche 100 par collage direct. Au préalable, ce substrat 104 a été pourvu de vias électriques non débouchants 106 (deux vias dans l'exemple), destinés à être mis en contact avec les lignes 102 lors du report.

A titre purement indicatif et nullement limitatif, le substrat 104 est en silicium et les vias 106 en polysilicium. Mais on peut également utiliser un substrat 104 en verre, d'autres matériaux semiconducteurs (par exemple SiC ou diamant) et des vias 106 en tungstène, voire en cuivre.

Ensuite, on amincit le substrat 104 par la face libre 108 de celui-ci jusqu'à ce que les vias 106 apparaissent et forment ainsi des vias électriques traversants 110 (figure 6D). Puis on forme une couche diélectrique 112 sur la face du substrat 104 où sont apparus les vias ; et l'on forme des plots de contact 114 à travers la couche 112.

Pour ce faire, on peut déposer une couche de silice puis former les plots en effectuant successivement une lithographie, une gravure, un décapage, un dépôt du même matériau que le matériau de remplissage des vias (tungstène, polysilicium voire cuivre) et un CMP.

Dans une variante de réalisation, dont la faisabilité dépend de l'épaisseur du substrat à reporter, on forme un substrat comportant les vias 110, la couche 112 et les plots 114 ; et l'on reporte ce substrat sur la face libre 105 de la couche 100.

Après retournement de la structure, l'ensemble formé par le substrat pourvu des vias 110 et par la couche 112 pourvue des plots 114 constituera le niveau inférieur du dispositif. Les plots 114 en constitueront les plots inférieurs et la face libre 118 de la couche 114 en constituera la face inférieure.

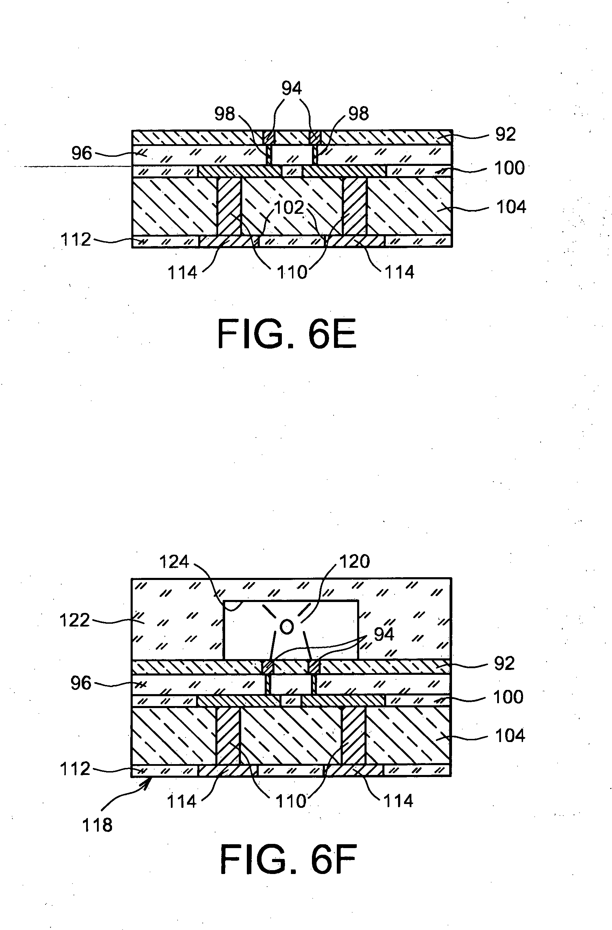

Le retournement est alors effectué (figure 6E) et la structure est amincie depuis sa face ayant : on élimine le substrat de silicium massif 88 et la couche d'oxyde 90, ce qui fait apparaître la couche de silicium 92, contenant les plots supérieurs 94.

Ensuite, la structure obtenue est recuite à une température de l'ordre de 1000°C. Ce recuit est effectué en vue d'activer les dopants implantés dans la couche de silicium 92 et de régénérer la structure cristalline du silicium après implantation et amincissement. En effet, la surface d'accueil des nano-objets doit être cristallographiquement parfaite pour permettre le report de ces nano-objets.

On obtient ainsi un dispositif du genre de celui qui a été décrit en faisant référence à la figure 1.

On peut maintenant connecter un nano-objet aux plots supérieurs 94. Par exemple, on peut greffer une molécule 120 (figure 6F) de façon que les extrémités de cette molécule soient respectivement connectées aux plots 94.

Si nécessaire, on forme ensuite un capot 122 comportant une cavité 124 qui permet d'isoler le nano-objet entre le capot et la face supérieure 126 du dispositif.

On obtient ainsi un dispositif du genre de celui qui a été décrit en faisant référence à la figure 2.

Pour former le capot et le fixer de façon étanche à cette face supérieure, on procède de la façon suivante : le capot est usiné de façon à créer des cavités permettant la protection des nano-objets (procédés de lithographie, gravure, décapage) ; puis il est reporté sur la face supérieure du dispositif par collage direct, sous vide (ou dans le fluide choisi) si nécessaire. Le dispositif est ensuite recuit ; la température de recuit dépend des propriétés du capot et du type de collage envisagé : ce collage peut être temporaire ou permanent.

En effet, le capot peut être reporté de façon temporaire (possibilité d'ouvrir la cavité après report du capot) ou de façon permanente. La température de recuit est ainsi ajustée en fonction de l'utilisation qui sera faite du capot.

Pour obtenir des dispositifs du genre de ceux qui sont représentés sur les figures 3 à 5, il est possible d'adapter les procédés qui viennent d'être décrits en faisant référence aux figures 6A à 6F.

A titre d'exemple, cette adaptation peut consister à _{:}
- prévoir, dans la couche 94, les plots et/ou les connexions qui sont nécessaires au dispositif que l'on veut obtenir,
- empiler, sur cette couche 94, des couches diélectriques qui sont respectivement pourvues de vias électriques ou de lignes électriquement conductrices de manière à obtenir l'empilement nécessaire au dispositif,
- reporter ensuite un substrat comportant les vias électriques traversants et une couche pourvue des plots de contact qui sont nécessaires au dispositif, ou reporter un substrat pourvu de vias électriques non traversants et poursuivre la fabrication du dispositif pour obtenir les vias traversants et la couche pourvue des plots de contact.

On précise que les plots supérieurs 94 peuvent être formés dans une couche qui est faite dans un substrat autre que du SOI, par exemple du silicium massif. Dans ce cas, on adapte le procédé de fabrication donné plus haut.

Les plots supérieurs 94 peuvent aussi être formés dans une couche faite d'un matériau électriquement isolant ; et, dans ce cas, on adapte également le procédé de fabrication donné plus haut.

De plus, un dispositif conforme à l'invention peut être pourvu de connexions électriques plus évoluées que les plots 12 (figure 1) en vue d'une connexion à un circuit intégré.

On peut par exemple remplacer les plots 12 par des lignes électriquement conductrices du genre des niveaux de redistribution (en anglais, *redistribution levels)* ou RDL.

Dans ce cas, le procédé de fabrication est adapté de la façon suivante : au lieu de former des plots 114 (figure 6D) dans la couche 112, on y forme les lignes électriquement conductrices.

La présente invention permet de caractériser des molécules actives de façon simple et moins coûteuse qu'avec les outils utilisés en électronique moléculaire. Elle apporte, par ailleurs, une alternative à la miniaturisation des composants en microélectronique et à l'augmentation de leurs fonctionnalités. En effet, le dispositif, objet de l'invention, peut permettre d'intégrer, sur le même substrat, des composants CMOS et des composants moléculaires.

## Revendications

1. Dispositif pour connecter au moins un nano-objet (2, 48, 62, 64) à au moins un système électrique externe (4, 52, 84), le dispositif comprenant :
- un premier niveau (6) comprenant au moins deux premiers éléments de contact électrique (8), prévus pour être connectés au nano-objet ;
- un deuxième niveau (10) comprenant au moins deux deuxièmes éléments de contact électrique (12), prévus pour être connectés au système électrique externe, les deuxièmes éléments ayant des dimensions supérieurs aux dimensions des premiers éléments ; et
- un niveau intermédiaire (14), compris entre les premier et deuxième niveaux et permettant de relier les premiers éléments aux deuxièmes éléments,
**caractérisé en ce que** :
- le premier niveau comprend en outre une première couche (16), pourvue des premiers éléments, les premiers éléments étant isolés électriquement du reste de la première couche;
- le deuxième niveau comprend en outre une deuxième couche (18), pourvue des deuxièmes éléments, les deuxièmes éléments étant isolés électriquement du reste de la deuxième couche, et une couche de liaison (20), disposée entre la deuxième couche et le niveau intermédiaire et comprenant au moins deux vias électriques traversants (22), respectivement en contact avec les deuxièmes éléments de contact électrique; et
- le niveau intermédiaire est prévu pour relier les vias du deuxième niveau aux premiers éléments de contact électrique et comprend un empilement d'au moins deux couches intermédiaires (23, 24, 40, 42, 68, 72, 76) respectivement pourvues d'un ensemble de lignes électriquement conductrices (25, 44, 70) qui sont électriquement isolées du reste de la couche correspondante et d'un ensemble de vias électriques traversants (26, 46, 74, 78) qui sont isolés électriquement du reste de la couche correspondante.

2. Dispositif selon la revendication 1, dans lequel le premier niveau (6) comprend plus de deux premiers éléments de contact électrique et dans lequel le niveau intermédiaire (14) est adapté pour connecter au moins l'un des deuxièmes éléments de contact électrique à au moins deux des premiers éléments de contact électrique.

3. Dispositif selon l'une quelconque des revendications 1 et 2, dans lequel le premier niveau (6) comprend plus de deux premiers éléments de contact électrique en vue de les connecter à au moins deux nano-objets (2, 48, 62, 64) ou à un seul nano-objet présentant plus de deux connecteurs, et dans lequel le niveau intermédiaire (14) est adapté pour connecter les nano-objets l'un à l'autre.

4. Dispositif selon l'une quelconque des revendications 1 à 3, dans lequel le premier niveau (6) comprend en outre au moins un circuit microélectronique (66) présentant des connexions électriques, et dans lequel le niveau intermédiaire (14) est adapté pour connecter le ou les nano-objets aux connexions électriques du circuit microélectronique.

5. Dispositif selon l'une quelconque des revendications 1 à 4, comprenant en outre au moins un capot (32, 54, 80, 82) définissant au moins une cavité qui est adaptée pour enfermer le ou lès nano-objets.

6. Dispositif selon la revendication 5, dans lequel le capot est adapté pour permettre au(x) nano-objet(s), qu'il contient d'interagir avec le milieu extérieur au capot.

7. Procédé de fabrication d'un dispositif pour connecter au moins un nano-objet (120) à au moins. un système électrique externe, dans lequel :
- on forme un premier niveau comprenant une première couche (92), pourvue d'au moins deux premiers éléments de contact électrique (94) qui sont isolés électriquement du reste de la première couche et sont prévus pour être connectés au nano-objet ;
- on forme un niveau intermédiaire comprenant un empilement d'au moins deux couches intermédiaires (96, 100), respectivement pourvues d'un ensemble de lignes électriquement conductrices (102) qui sont isolées électriquement du reste des couches intermédiaires et d'un ensemble de vias électriques traversants (98) qui sont isolés électriquement du reste des couches intermédiaires et qui sont respectivement en contact, d'un côté, avec les premiers éléments et, de l'autre côté, avec les lignes électriquement conductrices ; et
- on forme un deuxième niveau comprenant une deuxième couche (112), pourvue d'au moins deux deuxièmes éléments de contact électrique (114) qui sont isolés électriquement du reste de la deuxième couche et sont prévus pour être connectés au système électrique externe, et une couche de liaison (104), disposée entre la deuxième couche et le niveau intermédiaire et comprenant au moins deux autres vias électriques traversants (110), respectivement en contact, d'un côté, avec les deuxièmes éléments de contact électrique, et, de l'autre côté, avec les lignes électriquement conductrices du niveau intermédiaire.

8. Procédé selon la revendication 7, dans lequel les lignes conductrices d'au moins un des niveaux, pris parmi le premier niveau, le deuxième niveau et le niveau intermédiaire, sont en silicium , et les vias sont formés par s'iliciuration d'ouvertures préalablement formées sur lesdites lignes dans la ou les couches du niveau correspondant et par remplissage de tout ou partie desdites ouvertures par un matériau électriquement conducteur.

9. Procédé selon la revendication 7, dans lequel, pour former le deuxième niveau :
- on utilise un substrat (104) comprenant des vias électriques non traversants (106),
- on reporte ce substrat sur le niveau intermédiaire,
- on amincit ce substrat pour obtenir les autres vias électriques traversants (110), et
- on forme la couche de liaison (112) et les deuxièmes éléments de contact électrique (114) sur le substrat ainsi aminci.

10. Procédé selon la revendication 7, dans lequel, pour former le deuxième niveau, on reporte, sur le niveau intermédiaire, un substrat comprenant les vias électriques traversants (110), la couche de liaison (112), et les deuxièmes éléments de contact électrique (114).

11. Procédé selon l'une quelconque des revendications 9 et 10, dans lequel le substrat comprenant le deuxième niveau est reporté sur le niveau intermédiaire par collage direct, ou collage moléculaire.

12. Procédé selon l'une quelconque des revendications 7 à 11, dans lequel la première couche (92) est semiconductrice et dans lequel on forme les premiers éléments de contact électrique (94) par implantation de dopants dans la première couche.

13. Procédé selon la revendication 12, dans lequel, pour former le premier niveau, on utilise un substrat de type silicium sur isolant (86), comprenant un substrat de base (88), une couche d'oxyde (90) sur le substrat de base et une couche de silicium (92) sur la couche d'oxyde, la première couche est constituée par la couche de silicium et, après avoir reporté le deuxième niveau sur le niveau intermédiaire, lui-même étant formé sur le premier niveau, on éliminé le substrat de base et la couche d'oxyde.

14. Procédé selon la revendication 13, dans lequel on reporte un capot, présentant au moins une cavité, sur le premier niveau du dispositif.

15. Procédé selon la revendication 14, dans lequel le capot est reporté par collage direct sur le premier niveau du dispositif.

16. Procédé selon l'une quelconque des revendications 14 et 15, dans lequel le capot est reporté de façon temporaire, faisant ainsi du dispositif une interface ou plateforme réutilisable, ou de façon permanente.

## Patentansprüche

1. Vorrichtung zum Verbinden wenigstens eines Nano-Objekts (2, 48, 62, 64) mit wenigstens einem externen elektrischen System (4, 52, 84), wobei die Vorrichtung umfasst:
- ein erstes Niveau (6), umfassend wenigstens zwei erste elektrische Kontaktelemente (8), die mit dem Nano-Objekt verbunden werden sollen;
- ein zweites Niveau (10), umfassend wenigstens zwei zweite elektrische Kontaktelemente (12), die mit dem externen elektrischen System verbunden werden sollen, wobei die zweiten Elemente Abmessungen haben, die größer sind als die Abmessungen der ersten Elemente; und
- ein Zwischenniveau (14), das zwischen dem ersten und dem zweiten Niveau enthalten ist und es erlaubt, die ersten Elemente mit den zweiten Elementen zu verbinden,
**dadurch gekennzeichnet, dass**:
- Das erste Niveau ferner eine erste Schicht (16) umfasst, die mit ersten Elementen versehen ist, wobei die ersten Elemente elektrisch vom Rest der ersten Schicht isoliert sind;
- wobei das zweite Niveau ferner eine zweite Schicht (18) umfasst, die mit zweiten Elementen versehen ist, wobei die zweiten Elemente elektrisch vom Rest der zweiten Schicht isoliert sind, sowie eine Verbindungsschicht (20), die zwischen der zweiten Schicht und dem Zwischenniveau angeordnet ist und wenigstens zwei elektrische Durchführungswege (22) umfasst, die jeweils in Kontakt mit den zweiten elektrischen Kontaktelementen sind; und
- das Zwischenniveau dazu ausgelegt ist, die Durchführungswege des zweiten Niveaus mit den ersten elektrischen Kontaktelementen zu verbinden, und einen Stapel von mindestens zwei Zwischenschichten (23, 24, 40, 42, 68, 72, 76) umfasst, die jeweils mit einer Gruppe von elektrisch leitenden Leitungen (25, 44, 70) versehen sind, welche elektrisch vom Rest der entsprechenden Schicht isoliert sind, sowie mit einer Gruppe von elektrischen Durchführungswegen (26, 46, 74, 78), die elektrisch vom Rest der entsprechenden Schicht isoliert sind.

2. Vorrichtung nach Anspruch 1, bei der das erste Niveau (6) mehr als zwei erste elektrische Kontaktelemente umfasst, und bei der das Zwischenniveau (14) dazu ausgelegt ist, wenigstens eines der zweiten elektrischen Kontaktelemente mit wenigstens zwei der ersten elektrischen Kontaktelemente zu verbinden.

3. Vorrichtung nach einem der Ansprüche 1 und 2, bei der das erste Niveau (6) mehr als zwei erste elektrische Kontaktelemente umfasst, um sie mit wenigstens zwei Nano-Objekten (2, 48, 62, 64) oder mit einem einzigen Nano-Objekt zu verbinden, das mehr als zwei Verbinder aufweist, und bei der das Zwischenniveau (14) dazu ausgelegt ist, die Nano-Objekte miteinander zu verbinden.

4. Vorrichtung nach einem der Ansprüche 1 bis 3, bei der das erste Niveau (6) ferner wenigstens eine mikroelektronische Schaltung (66) umfasst, die elektrische Verbindungen aufweist, und bei der das Zwischenniveau (14) dazu ausgelegt ist, das oder die Nano-Objekt(e) mit den elektrischen Verbindungen der mikroelektronischen Schaltung zu verbinden.

5. Vorrichtung nach einem der Ansprüche 1 bis 4, ferner umfassend wenigstens eine Kappe (32, 54, 80, 82), die wenigstens einen Hohlraum definiert, welcher dazu ausgelegt ist, das oder die Nano-Objekt(e) einzuschließen.

6. Vorrichtung nach Anspruch 5, bei der die Kappe dazu ausgelegt ist, es dem/den Nano-Objekt(en), das/die sie enthält, zu ermöglichen, mit der Umgebung außerhalb der Kappe zu interagieren.

7. Verfahren zur Herstellung einer Vorrichtung zum Verbinden wenigstens eines Nano-Objekts (120) mit wenigstens einem externen elektrischen System, bei dem:
- Man ein erstes Niveau bildet, umfassend eine erste Schicht (92), die mit wenigstens zwei ersten elektrischen Kontaktelementen (94) versehen ist, welche elektrisch vom Rest der ersten Schicht isoliert sind und mit dem Nano-Objekt verbunden werden sollen;
- man ein Zwischenniveau bildet, umfassend einen Stapel aus wenigstens zwei Zwischenschichten (96, 100), die jeweils mit einer Gruppe von elektrisch leitenden Leitungen (102) versehen sind, welche elektrisch vom Rest der Zwischenschichten isoliert sind, sowie mit einer Gruppe von elektrischen Durchführungswegen (98), welche elektrisch vom Rest der Zwischenschichten isoliert sind und welche jeweils auf einer Seite mit den ersten Elementen und auf der anderen Seite mit den elektrisch leitenden Leitungen in Kontakt sind; und
- man ein zweites Niveau bildet, umfassend eine zweite Schicht (112), die mit wenigstens zwei zweiten elektrischen Kontaktelementen (114) versehen ist, welche elektrisch vom Rest der zweiten Schicht isoliert sind und welche mit dem externen elektrischen System verbunden werden sollen, sowie eine Verbindungssschicht (104), die zwischen der zweiten Schicht und dem Zwischenniveau angeordnet ist und wenigstens zwei weitere elektrische Durchführungswege (110) umfasst, die jeweils auf einer Seite in Kontakt mit den zweiten elektrischen Kontaktelementen und auf der anderen Seite in Kontakt mit den elektrisch leitenden Leitungen des Zwischenniveaus sind.

8. Vorrichtung nach Anspruch 7, bei der die leitenden Leitungen wenigstens eines der Niveaus, ausgewählt aus dem ersten Niveau, dem zweiten Niveau und dem Zwischenniveau, aus Silizium sind, und die Durchführungswege gebildet sind durch Silizierung von Öffnungen, die zuvor an den Leitungen in der oder den Schicht(en) des entsprechenden Niveaus gebildet sind, und durch vollständiges oder teilweises Füllen der Öffnungen mit einem elektrisch leitfähigen Material.

9. Verfahren nach Anspruch 7, bei dem man zum Bilden des zweiten Niveaus:
- Ein Substrat (104) verwendet, das nicht-durchführende elektrische Wege (106) umfasst,
- man dieses Substrat auf dem Zwischenniveau anbringt,
- man dieses Substrat verdünnt, um die anderen elektrischen Durchführungswege (110) zu erhalten, und
- man die Verbindungsschicht (112) und die zweiten elektrischen Kontaktelemente (114) auf dem derart verdünnten Substrat bildet.

10. Verfahren nach Anspruch 7, bei dem man zum Bilden des zweiten Niveaus auf dem Zwischenniveau ein Substrat anbringt, das die elektrischen Durchführungswege (110), die Verbindungsschicht (112) und die zweiten elektrischen Kontaktelemente (114) umfasst.

11. Verfahren nach einem der Ansprüche 9 und 10, bei dem das Substrat, das das zweite Niveau umfasst, durch direktes Kleben oder molekulares Kleben auf dem Zwischenniveau angebracht wird.

12. Verfahren nach einem der Ansprüche 7 bis 11, bei dem die erste Schicht (92) ein Halbleiter ist, und bei dem man die ersten elektrischen Kontaktelemente (94) durch Implantieren von Dotierungsmitteln in der ersten Schicht bildet.

13. Verfahren nach Anspruch 12, bei dem man zum Bilden des ersten Niveaus ein Substrat vom Typ Silizium auf Isolator (86) verwendet, umfassend ein Basissubstrat (88), eine Oxydschicht (90) auf dem Basissubstrat, sowie eine Siliziumschicht (92) auf der Oxydschicht, wobei die erste Schicht durch die Siliziumschicht gebildet ist, und man nach dem Anbringen des zweiten Niveaus auf dem Zwischenniveau, welches selbst wiederum auf dem ersten Niveau gebildet ist, das Basissubstrat und die Oxydschicht entfernt.

14. Verfahren nach Anspruch 13, bei dem man eine Kappe, die wenigstens einen Hohlraum aufweist, auf dem ersten Niveau der Vorrichtung anbringt.

15. Verfahren nach Anspruch 14, bei dem die Kappe durch direktes Kleben auf dem ersten Niveau der Vorrichtung angebracht wird.

16. Verfahren nach einem der Ansprüche 14 und 15, bei dem die Kappe vorübergehend angebracht wird, was somit aus der Vorrichtung eine wiederverwertbare Schnittstelle oder Plattform macht, oder permanent.

## Claims

1. Device for connecting at least one nano-object (2, 48, 62, 64) to at least one external electrical system (4, 52, 84), which device includes:
- a first level (6) including at least two first electrical contact elements (8), intended to be connected to the nano-object;
- a second level (10) including at least two second electrical contact elements (12), intended to be connected to the external electrical system, in which the second elements have larger dimensions than the dimensions of the first elements; and
- an intermediate level (14), located between the first and second levels and making it possible to connect the first elements to the second elements,
**characterized in that**:
- the first level also includes a first layer (16), equipped with the first elements, in which the first elements are electrically insulated from the rest of the first layer;
- the second level also includes a second layer (18), equipped with the second elements, in which the second elements are electrically insulated from the rest of the second layer (20), and a bonding layer, arranged between the second layer and the intermediate level and including at least two electrical through-vias (22), respectively in contact with the second electrical contact elements; and
- the intermediate level is intended to connect the vias of the second level with the first electrical contact elements and includes a stack of at least two intermediate layers (27 24, 40, 42, 68, 72, 76), respectively equipped with a set of electrically conductive lines (25, 44, 70) that are electrically insulated from the rest of the corresponding layer, and a set of electrical through-vias (26, 46, 74, 78) that are electrically insulated from the rest of the corresponding layer.

2. Device according to claim 1, in which the first level (6) includes more than two first electrical contact elements and in which the intermediate level (14) is suitable for connecting at least one of the second electrical contact elements to at least two of the first electrical contact elements.

3. Device according to anyone of claims 1 and 2, in which the first level (6) includes more than two first electrical contact elements for being connected to at least two nano-objects (2, 48, 62, 64) or to a single nano-object having more than two connectors, and in which the intermediate level (14) is suitable for connecting the nano-objects to one another.

4. Device according to anyone of claims 1 to 3, in which the first level (6) also includes at least one microelectronic circuit (66) having electrical connections, and in which the intermediate level (14) is suitable for connecting the nano-object(s) to the electrical connections of the microelectronic circuit.

5. Device according to anyone of claims 1 to 4, also including at least one cap (32, 54, 80, 82) defining at least one cavity that is suitable for enclosing the nano-object(s).

6. Device according to claim 5, in which the cap is suitable for enabling the nano-object(s) that it contains to interact with the environment outside the cap.

7. Method for producing a device for connecting at least one nano-object (120) to at least one external electrical system, in which:
- a first level is formed, including a first layer (92) equipped with at least two first electrical contact elements (94) that are electrically insulated from the rest of the first layer and intended to be connected to the nano-object;
- an intermediate level is formed, including a stack of at least two intermediate layers (96, 100), respectively equipped with a set of electrically conductive lines (102) that are electrically insulated from the rest of the intermediate layers and a set of electrical through-vias (98) that are electrically insulated from the rest of the intermediate layers, and that are respectively in contact, on one side, with the first elements and, on the other side, with the electrically conductive lines; and
- a second level is formed, including a second layer (112), equipped with at least two second electrical contact elements (114) that are electrically insulated from the rest of the second layer and intended to be connected to the external electrical system, and a bonding layer (104), arranged between the second layer and the intermediate level and including at least two other electrical through-vias (110), respectively in contact, on one side, with the second electrical contact elements and, on the other side, with the electrically conductive lines of the intermediate level.

8. Method according to claim 7, in which the conductive lines of at least one of the levels, taken from the first level, the second level and the intermediate level, are made of silicon, and the vias are formed by silicidation of openings previously formed on said lines in the layer(s) of the corresponding level and by filling all or some of said openings with an electrically conductive material.

9. Method according to claim 7, in which, to form the second level:
- a substrate (104) including electrical blind vias (106) is used,
- this substrate is attached on the intermediate level,
- this substrate is thinned in order to obtain the other electrical through-vias (110), and
- the bonding layer (112) and the second electrical contact elements (114) are formed on the substrate thus thinned.

10. Method according to claim 7, in which, to form the second level, the substrate including the electrical through-vias (110), the bonding layer (112), and the second electrical contact elements (114) are attached on the intermediate level.

11. Method according to anyone of claims 9 and 10, in which the substrate including the second level is attached on the intermediate level by direct bonding, or molecular bonding.

12. Method according to anyone of claims 7 to 11, in which the first layer (92) is semiconductive and in which the first electrical contact elements (94) are formed by implantation of doping agents in the first layer.

13. Method according to claim 12, in which, to form the first level, a silicon-on-insulator-type substrate (86) is used, including a base substrate (88), an oxide layer (90) on the base substrate, and a silicon layer (92) on the oxide layer, the first layer consists of the silicon layer and, after having attached the second level on the intermediate level, itself formed on the first level, the base substrate and the oxide layer are removed.

14. Method according to claim 13, in which a cap, having at least one cavity, is attached on the first level of the device.

15. Method according to claim 14, in which the cap is attached by direct bonding on the first level of the device.

16. Method according to anyone of claims 14 and 15, in which the cap is attached temporarily, thus making the device a reusable interface or platform, or it is attached permanently.
